# EUROPÄISCHE PATENTANMELDUNG

(11) **EP 3 623 780 A1**
(43) Veröffentlichungstag der Anmeldung: **18.03.2020**
(21) Anmeldenummer: 18194206.1
(22) Anmeldetag: 13.09.2018
(51) Int. Cl.: G01J 5/08, G01J 3/10

(54) **MODULATION DER ABSTRAHLINTENSITÄT EINES IR-EMITTERS MITTELS VARIATION DER ABSTRAHLENDEN FLÄCHE**

(71) Anmelder: Hahn-Schickard-Gesellschaft für angewandte Forschung e.V., 78052 Villingen-Schwenningen (DE)
(72) Erfinder: Prof. Dr. Dehé, Alfons, 72770 Reutlingen (DE); Dr. Bittner, Achim, 74080 Heilbronn (DE); Dr. Biesinger, Daniel, 78054 Villingen-Schwenningen (DE)
(74) Vertreter: Hertin und Partner Rechts- und Patentanwälte PartG mbB

(57) **Zusammenfassung**

Die Erfindung betrifft einen modulierbaren Infrarot-Emitter umfassend ein MEMS-Heizelement und einen Aktuator, wobei der Aktuator Form und/oder Strukturänderungen des MEMS-Heizelements auslöst. Durch diese Form- und/oder Strukturänderung des MEMS-Heizelements kann das Verhältnis der Emissionsfläche zur Gesamtfläche variiert werden, wodurch eine Intensitätsänderung des emittierten Infrarotstrahls erzeugt wird. Die Erfindung betrifft weiterhin ein Herstellungsverfahren für den Infrarot-Emitter, ein Verfahren zur modulierten Emission von Infrarotrotstrahlung mittels des Infrarot-Emitters sowie bevorzugte Verwendungen des Infrarotemitters. Auch ein System umfassend den Infrarot-Emitter und eine Steuereinrichtung zur Regulation des Aktuators sind bevorzugt Gegenstand der Erfindung.

## Beschreibung

### BESCHREIBUNG

Die Erfindung betrifft einen modulierbaren Infrarot-Emitter umfassend ein MEMS-Heizelement und einen Aktuator, wobei der Aktuator Form und/oder Strukturänderungen des MEMS-Heizelements auslöst. Durch diese Form- und/oder Strukturänderung des MEMS-Heizelements kann das Verhältnis der Emissionsfläche zur Gesamtfläche variiert werden, wodurch eine Intensitätsänderung des emittierten Infrarotstrahls erzeugt wird. Die Erfindung betrifft weiterhin ein Herstellungsverfahren für den Infrarot-Emitter, ein Verfahren zur modulierten Emission von Infrarotrotstrahlung mittels des Infrarot-Emitters sowie bevorzugte Verwendungen des Infrarotemitters. Auch ein System umfassend den Infrarot-Emitter und eine Steuereinrichtung zur Regulation des Aktuators sind bevorzugt Gegenstand der Erfindung.

### Hintergrund und Stand der Technik

Modulierbare Infrarot-Emitter (IR-Emitter) sind für eine Vielzahl von Anwendungen der Spektroskopie relevant. Insbesondere die Spektroskopie von Gasen wird häufig mit Hilfe von Infrarotstrahlung vorgenommen, welche bei bestimmten Frequenzen Vibrationen der beteiligten Moleküle auslöst, die sich durch detektierbare Absorptionslinien im Spektrum bemerkbar machen.

Häufig kommt die photoakustische Spektroskopie zum Einsatz, bei der intensitätsmodulierte Infrarotstrahlung mit Frequenzen im Absorptionsspektrum eines in einem Gas zu detektierenden Moleküls eingesetzt wird. Ist dieses Molekül im Strahlengang vorhanden, findet eine modulierte Absorption statt, die zu Erwärmungs- und Abkühlungsprozessen führt, deren Zeitskalen die Modulationsfrequenz der Strahlung widerspiegeln. Die Erwärmungs- und Abkühlungsprozesse führen zu Expansionen und Kontraktion des Gases, wodurch Schallwellen mit der Modulationsfrequenz verursacht werden. Diese lassen dann sich durch Schalldetektoren (Mikrofone) oder Flusssensoren messen.

Die photoakustische Spektroskopie erlaubt die Detektion feinster Konzentrationen von Gasen und hat eine Vielzahl von Anwendungen. Beispielhaft ist die Detektion von CO₂, welche in der Forschung und der Klimatechnik eine Rolle spielt. Auch die Konzentration z. B. von Abgasen in der Luft kann so gemessen werden. Ebenso sind militärische Anwendungen relevant, bei denen kleinste Konzentrationen von Giftgas detektiert werden können.

Verschiedene Emitter werden als Strahlungsquelle für die genannten Anwendungen verwendet, mit unterschiedlichen Vor- und Nachteilen. Es können beispielsweise schmalbandige Laserquellen im Infrarotbereich eingesetzt werden. Diese erlauben die Verwendung hoher Strahlungsintensitäten und können mit Standardkomponenten hochfrequent moduliert werden, z. B. für die photoakustische Spektroskopie. Jedoch sind durch das schmale Spektrum des Lasers nur vom Absorptionsspektrum erfasste Moleküle detektierbar. Ebenso sind Laser relativ teuer. Will man verschiedene Moleküle detektieren, muss eine entsprechende Anzahl von Lasern verwendet werden.

Thermische, breitbandige Emitter sind ebenso bekannt. Diese haben den Vorteil eines breiten Spektrums und oft geringer Kosten. Jedoch ist die Modulationsfrequenz dieser Emitter beschränkt, eine direkte Modulation durch Variation der Stromzufuhr ist aufgrund thermischer Zeitkonstanten langsam und verschlechtert die Lebensdauer des Bauteils erheblich. Eine langsame Modulation hat oft eine Messung mit einem schlechten Signal-zu-Rauschverhältnis aufgrund des Eigenrauschens der Detektionskomponenten zur Folge. Eine externe Modulation durch die Verwendung sich drehender Chopperräder ist schneller, jedoch ist der Aufbau aufwendig und nicht derart kompakt und robust, wie es für viele Anwendungen wünschenswert wäre. Auch sind die Modulationsbandbreiten beschränkt und eine Variation der Rotationsgeschwindigkeit des Choppers ist aufgrund von Trägheiten schwerfällig.

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (engl. *microelectromechanical system,* kurz MEMS) sind sehr kompakt (Mikrometerbereich) bei gleichzeitig hervorragender Funktionalität und immer geringeren Herstellungskosten. Beispielsweise werden in der DE 10 2017 206 183 A1 schnelle und kompakte Kammantriebe als MEMS-Aktuatoren beschrieben.

Eine Verwendung von MEMS-Technologie zur Modulation einer thermisch erzeugten Infrarotstrahlung ist im Stand der Technik unbekannt.

### Aufgabe der Erfindung

Aufgabe der Erfindung ist es, einen modulierbaren Infrarot-Emitter sowie ein Verfahren zur Erzeugung modulierter Infrarotstrahlung ohne die Nachteile des Standes bereitzustellen. Insbesondere war es eine Aufgabe der Erfindung einen hochfrequent und variabel modulierbaren Infrarotemitter zur Verfügung zu stellen, welcher ein breites Spektrum an Infrarotstrahlung moduliert emittieren kann und sich gleichzeitig durch einen einfachen, kostengünstigen kompakten Aufbau auszeichnet.

### Zusammenfassung der Erfindung

Gelöst wird die Aufgabe durch die Merkmale der unabhängigen Ansprüche. Vorteilhafte Ausgestaltungen der Erfindung sind in den abhängigen Ansprüchen beschrieben.

In einem Aspekt betrifft die Erfindung einen modulierbareren Infrarot-Emitter umfassend
- ein Heizelement und
- einen Aktuator
wobei das Heizelement ein MEMS-Heizelement ist, umfassend erhitzbare Bereiche zur Emission von Infrarotstrahlung in eine Emissionsrichtung, wobei die Projektion der erhitzbaren Bereiche in Emissionsrichtung eine Emissionsfläche und die von dem MEMS-Heizelement aufgespannte Fläche eine Gesamtfläche bilden und der Aktuator konfiguriert ist, die Form und/oder Struktur des MEMS-Heizelementes zwischen einem ersten und zweiten Zustand zu ändern, sodass das Verhältnis der Emissionsfläche zur Gesamtfläche des MEMS-Heizelements in dem ersten Zustand um mindestens einen Faktor 2 geringer ist, als in dem zweiten Zustand.

Durch die Form- und/oder Strukturänderung des MEMS-Heizelements kann das Verhältnis der Emissionsfläche zur Gesamtfläche variiert werden. Dieses Verhältnis kann dabei zwischen zwei Extrempunkten variiert werden, die durch den ersten Zustand des Heizelements (Verhältnis minimal) und den zweiten Zustand Heizelements (Verhältnis maximal) repräsentiert werden. Hierfür kann die Emissionsfläche und/oder die Gesamtfläche geändert werden. Ziel ist es, eine zur Variation des Verhältnisses gleichlaufende Intensitätsänderung des emittierten Infrarotstrahls zu erzeugen. Im Gegensatz zu bekannten Intensitätsmodulationen bei Infrarotemittern durch Variation der Stromzufuhr ist die erfindungsgemäße Modulation nicht durch thermische Zeitkonstanten begrenzt. Durch die besondere Eignung der Vorrichtung zur Verwendung von MEMS-Aktuatoren können Modulationsfrequenzen von deutlich über 100 Hz erreicht werden. Derartige Modulationsfrequenzen sind insbesondere für die photoakustische Spektroskopie vorteilhaft. Der modulierbare Infrarot-Emitter eignet sich jedoch darüber hinaus für jeglichen Anwendungen, bei denen eine schnelle und zuverlässige Modulation einer Infrarot-Strahlung gefordert ist.

In erster Linie ist der modulierbare Infrarot-Emitter eine Vorrichtung, die elektromagnetische Strahlung aussendet. Diese Strahlung hat bevorzugt einen Wellenlängenbereich im Infrarot (IR) Bereich, insbesondere zwischen ca. 700 Nanometer (nm) und 1 Millimeter (mm) Wellenlänge. Die dementsprechende Frequenz der emittierten Strahlung kann im Bereich zwischen etwa 300 Gigahertz (GHz) bis 400 Terrahertz (THz) liegen. Das Spektrum kann ebenso bevorzugt anhand der Wellenzahl m⁻¹ bzw. cm⁻¹ wiedergegeben werden, wie es im Bereich der Spektroskopie üblich ist. Ein Fachmann weiß, wie die Umrechnung in diese Einheiten vorgenommen wird. Der Begriff Emitter bezeichnet bevorzugt die Vorrichtung, umfassend die Strahlungsquelle, welches durch das MEMS-Heizelement repräsentiert wird, wobei durch Änderungen der Form und/oder Struktur des MEMS-Heizelements das Verhältnis von Emissionsfläche zur Gesamtfläche des MEMS-Heizelements variiert werden kann.

Das Spektrum ist insbesondere so gewählt, dass es dem bevorzugten Anwendungsgebiet des Emitters, nämlich der Infrarotspektroskopie und insbesondere der photoakustischen Spektroskopie entspricht. Dabei ist insbesondere die Schwingungsanregung der zu spektroskopierenden und/oder zu detektierenden Gasmoleküle bevorzugt, welche je nach Gasmolekülen einem bevorzugten spektralen Bereich entsprechen. Beispielsweise ist für die Anregung von CO₂ Molekülen ein Spektralbereich des IR-Emitters umfassen eine Wellenlänge von etwa 2,4 Mikrometern (µm) geeignet. Besonders bevorzugte Wellenlängenbereich der Infrarotstrahlung sind 700 nm bis 10 µm, bevorzugt 1 bis 5 µm, besonders bevorzugt 2 µm bis 3 µm.

Die Strahlung kann dabei isotrop, d.h. in alle Raumrichtungen gleichmäßig ausgehend vom Emitter ausgestrahlt werden. Dann kann die Emissionsrichtung z. B. anhand struktureller Merkmale des Emitters in diese Richtung festgelegt werden. Gleichmäßig bedeutet in diesem Zusammenhang bevorzugt mit gleicher Intensität der Strahlung. Intensität ist insbesondere definiert als Flächenleistungsdichte und hat bevorzugt die Einheit Watt pro Quadratmeter oder abgekürzt W/m². Bevorzugt ist gegenüber einer isotropen Emission der Strahlung jedoch eine Bündelung der Strahlung in Form eines Strahls, der entlang einer bevorzugten Emissionsrichtung in Form einer Grade orientiert ist. Da die Strahlung eines Emitters insbesondere ohne zusätzliche Komponenten typischerweise divergiert und bevorzugt bezüglich der emittierenden Fläche z. B. durch das Lambertsche Gesetz beschrieben werden kann, können zusätzliche Komponenten wie z. B. Linsen im Emitter integriert oder extern angebracht sein, die für eine Bündelung bzw. Kollimation des Strahls sorgen. Ein Fachmann weiß, wie er durch das Design der Strahlungsquelle sowie durch Verwendung weiterer Komponenten das Emissionsprofil der Strahlungsquelle so formt, dass ein gewünschtes Strahlprofil sowie eine gewünschte Emissionsrichtung resultieren. Dabei kann der modulierbare IR-Emitter bevorzugt nur die eigentliche Strahlungsquelle ohne zusätzliche Linsen umfassen als auch ein System umfassend Strahlungsquelle und mindestens einer Linse zur Kollimation des Strahls sein. Der Begriff Strahl soll im weiteren Verlauf den vorzugsweise gebündelten Teil der Strahlung entlang der bevorzugten Emissionsrichtung des Emitters beschreiben, welcher vom Emitter ausgesandt wird, wobei insbesondere die Bereiche der größten Intensität entlang dieser Richtung den Strahl definieren.

Der Emitter ist modulierbar, das bedeutet, dass die Intensität der emittierten Strahlung, bevorzugt die Intensität des Strahls im zeitlichen Verlauf kontrollierbar geändert werden kann. Die Modulation soll bevorzugt eine zeitliche Änderung der Intensität als messbare Größe hervorrufen. Das bedeutet z. B., dass die Intensität im zeitlichen Verlauf zwischen der innerhalb des Messzeitraums gemessenen schwächsten Intensität und der innerhalb desselben Zeitraums gemessenen stärksten Intensität ein Unterschied besteht, der größer ist als die Sensibilität eines für das Strahlungsspektrum und die Anwendung typischerweise verwendeten Geräts zur Messung oder Bestimmung der Intensität. Bevorzugt ist der Unterschied deutlich größer als ein Faktor 2 zwischen der stärksten und der schwächsten einstellbaren Intensität. Ein modulierbarer Infrarotemitter hat eine Vielzahl von Anwendungen. Als relevante Anwendung ist insbesondere jede Form von Infrarotspektroskopie und insbesondere die photoakustische Spektroskopie zu nennen.

Zur Erzeugung der Infrarotstrahlung ist ein thermischer Emitter in Form eines MEMS-Heizelements vorgesehen. Unter einem MEMS-Heizelement wird bevorzugt ein Heizelement mit Abmessungen der Größenordnung Mikrometer (µm) verstanden. Dabei umfasst das Heizelement eine erhitzbare Schicht aus einem leitfähigen Material, welches bei Durchfluss eines elektrischen Stroms joulesche Wärme produziert. Die produzierte Wärme zeigt bevorzugt eine Abhängigkeit vom ohmschen Widerstand des Elements und vom Quadrat der Stromstärke bzw. vom Quadrat der angelegten Spannung und dem inversen ohmschen Widerstand, je nachdem, ob eine Strom- oder eine Spannungsquelle verwendet wird. In einem Gleichgewichtszustand ist die produzierte Wärme gleich zu den Wärmeverlusten durch Wärmeleitung, Konvektion und Wärmestrahlung (synonym: thermische Strahlung, Infrarotstrahlung), welche an den äußeren Grenzflächen der stromdurchflossenen erhitzbaren Schicht abgegeben wird. Wie dem Fachmann bekannt ist, verursacht die produzierte Wärme unter anderem thermische Strahlung insbesondere durch thermische Bewegung von Teilchen, welche z. B. eine Beschleunigung von Ladungsträgern und/oder oszillierende Dipolmomente zur Folge hat. Somit kann durch eine stromdurchflossene erhitzbare Schicht gezielt Infrarotstrahlung erzeugt werden. Die erhitzbare Schicht ist bevorzugt aus Metall, beispielsweise aus Wolfram oder aus Platin. Durch Anlegen einer geeigneten Spannung und den daraus resultierenden Stromfluss wird joulesche Wärme und somit letztendlich Infrarotstrahlung erzeugt. Das Strahlungsspektrum lässt sich dabei bevorzugt angenähert durch das Plancksche Strahlungsgesetz beschreiben, wobei dem Fachmann die Unterschiede einer realen erhitzbaren Schicht zu einem schwarzen Körper bekannt sind, beispielsweise der Emissionsgrad oder die reale Abweichung von einem thermischen Gleichgewicht des Körpers. Trotz dieser Abweichungen wird das erzeugte Spektrum und dessen Intensität im Wesentlichen von der Temperatur und der abstrahlenden Fläche gemäß dem Planckschen Strahlungsgesetz beschrieben. Somit kann ein Fachmann durch gezieltes Design des MEMS-Heizelements ein bevorzugtes Spektrum mit einer bevorzugten Intensitätsverteilung erzielen. Hierzu sind neben dem Material und der geometrischen Ausgestaltung des Heizelements bevorzugt die zur Verfügung gestellte elektrische Energie, eine Oberflächenbehandlung der abstrahlenden Grenzfläche sowie die Größe der Wärmeverluste des Heizelements neben der Wärmestrahlung maßgeblich. Die Größe dieser Wärmeverluste wird beispielsweise bestimmt durch die Wärmeleitfähigkeit zwischen dem Heizelement und den angrenzenden Materialien und/oder Fluiden sowie deren Wärmekapazität und der Größe der Grenzfläche(n).

Das strukturierte MEMS-Heizelement spannt eine zweidimensionale Ebene, die Gesamtfläche, auf. Diese ist bevorzugt eine in Emissionsrichtung orientierte Oberfläche des MEMS-Heizelements. In Emissionsrichtung orientiert bezeichnet den Umstand, dass eine Normale der Fläche in Emissionsrichtung zeigt. Unter Aufspannen ist bevorzugt zu verstehen, dass die äußeren Umrandungen dieser Oberfläche des MEMS-Heizelements ebenfalls die Umrandungen der Gesamtfläche darstellen. Die Gesamtfläche ist bevorzugt eine zusammenhängende Fläche, die durch diese Umrandungen definiert ist. Die äußeren Umrandungen der in Emissionsrichtung orientierten Oberfläche des MEMS-Heizelements wiederum werden durch die äußeren Umrandungen der funktionellen Bereiche des Heizelements definiert, welche ihrerseits z. B. durch die (nicht-) erhitzbaren Bereiche und/oder deren Projektion in Emissionsrichtung gebildet werden. Die Gesamtfläche kann bevorzugt ebenso nach außen durch eine Rahmenstruktur aufgespannt werden, in dem die erhitzbaren Bereiche bewegbar gelagert vorliegen. Die Projektion der erhitzbaren Bereiche in Emissionsrichtung bzw. auf die Gesamtfläche wird Emissionsfläche genannt. Die Emissionsfläche kann eine zusammenhängende Fläche sein oder aus mehreren Teilflächen gebildet werden, wobei dann zwischen den Emissionsflächen bevorzugt nicht erhitzbare Bereich bzw. deren Projektionen vorliegen. Ein nicht-erhitzbarer Bereich ist bevorzugt dadurch bestimmt, dass er zwischen mindestens zwei erhitzbaren Bereichen liegt und selbst kein erhitzbarer Bereich ist und in der Ebene der Gesamtfläche liegt bzw. dort eine Projektion aufweist. Ein nicht-erhitzbarer Bereich ist mithin Bestandteil der Gesamtfläche, aber kein Bestandteil der Emissionsfläche. Es kann ebenso eine Rahmenstruktur vorliegen, sodass die Projektionen der nicht erhitzbaren Bereiche all jene Flächen innerhalb der Rahmenstruktur sind, welche nicht Emissionsfläche sind.

Im Folgenden soll bevorzugt der Ausdruck "Projektion der nicht-erhitzbaren Bereiche" anstatt "nicht-erhitzbare Bereiche" verwendet werden. Diese Projektion kann eine zusammenhängende Fläche sein und/oder aus mehreren Teilflächen gebildet werden. Die Gesamtfläche wird demnach gebildet durch die Emissionsfläche(n) und die Projektion(en) der nicht-erhitzbaren Bereiche. Die Modulation der IR-Emissionsintensität über die Gesamtfläche wird im Wesentlichen durch den Infrarotstrahl abgebildet. Das bedeutet insbesondere, dass eine Modulation der Intensität der IR-Strahlung über die Gesamtfläche zu einem Zeitpunkt im Wesentlichen einer Modulation der Intensität des IR-Strahls zu einem späteren Zeitpunkt entspricht.

Wird der IR-Strahl, z. B. durch Fokussierung in eine Abbildung überführt, entspricht eine Modulation der abgebildeten Intensität des IR-Strahls im Wesentlichen der Modulation der Intensität über der Gesamtfläche des Heizelements bzw. ist hierzu proportional. Wird beispielsweise die Gesamtfläche bei gleichbleibender Emissionsfläche verdoppelt, so wird die durchschnittliche Intensität des IR-Strahles im Anschluss an die Gesamtfläche halbiert, da eine gleichbleibende Emissionsenergie über eine doppelt so große Fläche abgestrahlt wird. Auch bei anschließender Fokussierung des IR-Strahles setzt sich Intensitätsänderung im Emissionsverlauf fort, sodass im Wesentlichen eine Halbierung der Intensität in den weiteren Abbildungen des IR-Strahles zu verzeichnen ist.

Zur Modulation der Intensität der Infrarotstrahlung kann zwischen einem ersten Zustand des Heizelements und einem zweiten Zustand des Heizelements dessen Form und/oder Struktur geändert werden, sodass die Emissionsfläche oder die Gesamtfläche sich ändert. Zu diesem Zweck können die Größe der Emissionsfläche und/oder Gesamtfläche bzw. insbesondere deren Verhältnis variiert werden. Bevorzugt wird das Verhältnis der Emissionsfläche zur Gesamtfläche durch den Quotienten zwischen diesen beiden Größen ausgedrückt.

In einer Ausführungsform kann z. B. zwischen einem ersten Zustand und einem zweiten Zustand die Emissionsfläche bei gleichbleibender Gesamtfläche vergrößert werden. Hierzu kann die gesamte Fläche der erhitzbaren Bereiche vergrößert werden. Da die Gesamtfläche in diesem Bespiel gleichgroß bleibt, bedeutet das gleichzeitig, dass die Projektion der nicht-erhitzbaren Bereiche, die zusammen mit der Emissionsfläche die Gesamtfläche bildet, beim Übergang vom ersten zum zweiten Zustand verkleinert wird. Es kann dabei bevorzugt sein, dass die Gesamtfläche im ersten Zustand im Wesentlichen Projektionen nicht erhitzbarer Bereiche umfasst und in einem anderen Zustand im Wesentlichen Emissionsfläche(n). In dieser beispielhaften Ausführungsform wird die Gesamtenergie der über die Gesamtfläche pro Zeiteinheit emittierten Strahlung und in demselben Verhältnis die Intensität der IR-Strahlung über die (gleichbleibende) Gesamtfläche vergrößert.

Es kann in einer anderen Ausführungsform ebenso bevorzugt sein, dass zwischen einem ersten und einem zweiten Zustand die Gesamtfläche bei gleichbleibender Emissionsfläche verkleinert wird. Zu diesem Zweck bleibt die Fläche der erhitzbaren Bereiche gleichgroß, während die Fläche der Projektion der nicht erhitzbaren Bereiche verkleinert wird.

In dieser Ausführungsform bleibt die über die Gesamtfläche pro Zeiteinheit emittierte Energie der IR-Strahlung unverändert. Die über die Gesamtfläche ausgestrahlte Intensität der IR-Strahlung wird somit vergrößert, in dem eine gleichbleibende Gesamtenergie über eine vergrößerte Gesamtfläche emittiert wird.

Ist das MEMS-Heizelement durch mehrere erhitzbare Bereiche, beispielsweise in Streifenform, charakterisiert, dann wird der emittierte Strahl des IR-Emitters durch die vereinigten Teilstrahlen der einzelnen Emissionsflächen innerhalb der Gesamtfläche und deren Intensität charakterisiert. Das genaue geometrische Abstrahlverhalten der einzelnen Emissionsflächen ist dabei bevorzugt unter anderem von dem Gesamtdesign des IR-Emitters abhängig, beispielsweise von der geometrischen Ausgestaltung der erhitzbaren Bereiche, der Positionierung einer Linse zur Kollimation des Strahls etc.

Es ist bevorzugt, dass die erhitzbaren Bereiche elektrisch miteinander kontaktiert sind und so eine gemeinsame Kontaktierung zu einer elektrischen Energiequelle aufweisen.

Das MEMS-Heizelement ist bevorzugt zumindest teilweise freistehend und erlaubt z. B. innerhalb des IR-Emitters thermische Dehnungen aufgrund von starken Temperaturänderungen. Teilweise freistehend bedeutet, dass es an den Grenzflächen zumindest teilweise nicht kraft- und/oder formschlüssig mit anderen Elementen des Emitters verbunden ist und daher einen Freiheitsgrad der Bewegung in eine im Wesentlichen zur Grenzfläche senkrechten Richtung aufweist.

Begriffe wie im Wesentlichen, ungefähr, etwa, ca. etc. beschreiben bevorzugt einen Toleranzbereich von weniger als ± 40%, bevorzugt weniger als ± 20%, besonders bevorzugt weniger als ± 10 %, noch stärker bevorzugt weniger als ± 5% und insbesondere weniger als ± 1%. Ähnlich beschreibt bevorzugt Größen die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Der Aktuator ist konfiguriert, die Form und/oder Struktur des MEMS-Heizelementes zwischen einem ersten und zweiten Zustand zu ändern, sodass das Verhältnis der Emissionsfläche zur Gesamtfläche des MEMS-Heizelements in dem ersten Zustand um mindestens einen Faktor 2 geringer ist als in dem zweiten Zustand. Vorliegend setzt ein Aktuator insbesondere ein elektrisches Steuerungssignal in eine Bewegung um. Es kann sich dabei um einen MEMS-Aktuator handeln, welcher z. B ein elektrostatischen Aktuator ist. Dieser kann direkt mit dem MEMS-Heizelement verbunden sein. Das MEMS-Heizelement umfasst bevorzugt Elemente, die in mindestens einem Freiheitsgrad beweglich sind, um die Form und/oder Strukturänderung zu realisieren. Eine Form und/oder Strukturänderung bewirkt bevorzugt eine Änderung der Größe der Emissionsfläche und/oder der Gesamtfläche des MEMS-Heizelements und kann darüber hinaus bevorzugt eine Änderung der Größe des gesamten Heizelements und/oder von dessen Oberfläche(n) verursachen.

Die beweglichen Elemente müssen dabei dergestalt gelagert sein, dass eine gewünschte Bewegung in großer Zahl wiederholbar durchführbar ist und die gewünschte Flächenänderung zum Resultat hat. Dafür kann ein beweglich gelagertes Element z. B. über eine Linearführung mit den starren Elementen des Heizelements und/oder der restlichen Komponenten des Emitters verbunden sein. Eine Linearführung erlaubt bevorzugt eine lineare Bewegung entlang einer Richtung und unterbindet eine Bewegung in eine andere Richtung bzw. schränkt den Freiheitsgrad der Bewegung in andere Richtungen ein. Gleichzeitig erlaubt eine Linearführung bevorzugt eine möglichst reibungs- und wartungsarme Bewegung entlang dieser Richtung, beispielsweise durch Wälzkörper und/oder Gleitlager. Auch kann es bevorzugt sein, Radiallager zu verwenden, um Drehbewegungen von beweglichen Elementen zu ermöglichen. Insbesondere kann das MEMS-Heizelement eine Federstruktur umfassen, wobei die beweglichen Elemente federartig miteinander verbunden sind und eine Streckung oder Stauchung der Federstruktur des MEMS-Heizelements erreicht werden kann.

Die bewegbaren Elemente umfassen bevorzugt die erhitzbaren Bereiche bzw. sind durch die erhitzbaren Bereiche realisiert. Der mindestens eine Aktuator wiederum ist dergestalt mit den bewegbaren Elementen gekoppelt, dass die gewünschte Bewegung ausführbar ist.

Aktuator und bewegbare Elemente des Heizelementes können dabei bevorzugt direkt miteinander verbunden sein. Es kann sogar bevorzugt sein, dass sowohl die Elemente als auch Aktuator dasselbe Substrat umfassen und/oder aus diesem gefertigt sind. Es kann dabei nicht nur eine mechanische, sondern ebenso eine thermische und/oder elektrische Kopplung zu dem Aktuator bestehen. Durch die thermische Kopplung kann ein gewünschter nichtstrahlender Wärmeverlust des Heizelements erreicht werden, welcher die Strahlungs- und/oder Modulationseigenschaften des Heizelements in gewünschter Weise beeinflusst. Durch eine elektrische Kopplung kann die elektrische Kontaktierung der erhitzbaren Schicht aus leitfähigen Material des Heizelements erreicht werden.

Der Aktuator ist bevorzugt konfiguriert für die Form- und/oder Strukturänderung, wenn er diese vom ersten zum zweiten Zustand mit der gewünschten Geschwindigkeit und Wiederholrate durchführen kann und entsprechend den Anforderungen durch ein elektrisches Signal angesteuert werden kann.

Durch die Struktur und/oder Formänderung wird wie beschrieben eine Intensitätsänderung über die Gesamtfläche erzeugt, die eine Intensitätsänderung der von dem MEMS-Heizelement in Emissionsrichtung emittierten IR-Strahlung resultiert. Die Erzeugung modulierter Infrarotstrahlung ist das eigentliche Ziel des beschriebenen modulierbaren IR-Emitters. Dabei ist bevorzugt, dass die emittierte Infrarotstrahlung im ersten Zustand deutlich geringer ist als in einem zweiten Zustand. Insbesondere ist bevorzugt, dass diese Intensität im mindesten einen Faktor 2 geringer ist. Das Verhältnis zwischen der durch den Emitter einstellbaren maximalen und minimalen Intensität der emittierten IR Strahlung kann bevorzugt auch als Extinktionsverhältnis bezeichnet und ist bevorzugt gemeinsam mit der Modulationsfrequenz ein Ausdruck der erzielbaren Modulationseigenschaften des Emitters. Es kann direkt aus dem Quotienten zwischen maximaler Intensität und minimaler Intensität bestimmt und bevorzugt direkt durch diesen Quotienten angegeben werden. Es kann aber auch bevorzugt sein, dass dieses Verhältnis in der logarithmischen Skala Dezibel (dB) ausgedrückt wird, wie es beispielsweise in der Nachrichtentechnik üblich ist. Durch den beschriebenen Aufbau des Emitters kann dieser besonders kompakt und einfach gehalten werden, wodurch eine hohe Modulationsfrequenz und - bandbreite erzielbar ist, da die bewegbaren Elemente aufgrund ihrer geringen Masse nur kleine Trägheiten besitzen und keine großen Kräfte zur Bewegung benötigt werden. Auch ist ein solcher Aufbau besonders einfach und kostengünstig durch übliche Herstellungsschritte der MEMS- und/oder Halbleitertechnologie möglich. Bevorzugt kann dabei der IR-Emitter mindestens teilweise integriert, in einem Herstellungsschritt und/oder aus einem Substrat hergestellt werden. Insbesondere in einigen Ausführungsformen der Erfindung kann dabei eine besonders hohe Modulationstiefe (Extinktionsverhältnis) erreicht werden.

Die bei den gewünschten Modulationstiefen erreichbaren maximalen Modulationsfrequenzen sollten bevorzugt mindestens 1 Kilo-Hertz (kHz), besonders bevorzugt mindestens 10 kHz, stärker bevorzugt mindestens 20 kHz, ganz besonders bevorzugt mindestens 30 kHz und insbesondere mindestens 100 kHz betragen. Besonders bevorzugt ist es, für eine Anwendung in der photoakustischen Spektroskopie Modulationsfrequenzen im Bereich des Hörschalls und/oder Ultraschalls zu erzielen. Die Modulationsbandbreite, über welche die gewünschte Modulationstiefe erreicht wird, betrifft bevorzugt den gesamten Frequenzbereich von 0 Hz bis zur maximalen Modulationsfrequenz.

Die gewünschte Modulation kann bevorzugt in einem entsprechenden zeitlichen Verlauf der emittierten Strahlungsintensität Ausdruck finden. Um die Umsetzbarkeit eines solchen gewünschten zeitlichen Intensitätsverlaufs zu ermitteln, sind insbesondere die Modulationstiefe und die Bandbreite über der diese Modulationstiefe im Wesentlichen erreichbar ist, von Bedeutung. Auch die Auflösung einer elektronischen Ansteuerung des IR-Emitters ist bevorzugt relevant für die Umsetzbarkeit. Dabei ist beispielsweise bedeutsam, welche verschiedenen Intensitätsstufen zwischen minimaler und maximaler Intensität mit welcher Frequenz erreicht werden können. Es ist bevorzugt, dass der IR-Emitter eine elektrische Ansteuerung aufweist, mit der das MEMS-Heizelement und die durch den mindestens einen Aktuator hevorgerufene Form- und/oder Strukturänderung des Heizelements gesteuert wird.

Eine solche kann z. B. über eine Steuerungseinrichtung realisiert werden. Durch eine Ansteuerung können die gewünschten Spektren, Intensitäten und Modulationen eingestellt werden. Ansteuerung bedeutet bevorzugt, dass elektrische Steuersignale direkt an den Aktuator und das MEMS-Heizelement übermittelt werden, welche in den gewünschten Strahlungseigenschaften resultieren. Bei dem MEMS-Heizelement kann so insbesondere eine bestimmte Temperatur und/oder ein bestimmter zeitlicher Temperaturverlauf eingestellt werden. Außerdem kann durch die vom Aktuator ausgelöste Form- und/oder Stukturänderung (eventuell in Abstimmung mit einem Temperaturverlauf) ein bestimmtes Modulationssignal erzielt werden. Typischerweise handelt es sich um ein analoges Signal, welches von einer Steuereinrichtung erzeugt wird. Diese wiederum kann bevorzugt ein geeignetes, digitales, elektronisches Signal, beispielsweise durch einen Steuerungscomputer erhalten, welche dann vorteilhafterweise von der Steuereinrichtung in geeignete Ansteuerungssignale übersetzt wird

Der Aufbau des modulierbaren Infrarot-Emitters soll nun zur Illustration anhand zweier konkreter Ausführungen verdeutlicht werden, ohne dass dieser auf die aufgeführten Ausführungsformen beschränkt ist. Der IR-Emitter ist dabei in einer Ausführungsform bevorzugt in einem Gehäuse untergebracht, welches aus einem unteren Träger, aus Seitenteilen und aus einem Deckelement besteht. Im Deckelement liegt bevorzugt eine Öffnung oder ein für die IR-Strahlung transparenter Bereich vor. Das Deckelement kann weiterhin mindestens eine Linse und/oder einen optischen Filter umfassen. Zwischen Träger, Deckelement und Seitenteilen können jeweils Dichtelemente vorliegen. Diese Dichtelemente werden bevorzugt verwendet, um einen thermischen Austausch des Innern des Emitters, in dem das MEMS-Heizelement vorliegt, mit der äußeren Umgebung des IR-Emitters zu reduzieren. Das MEMS-Heizelement besteht hier bevorzugt aus einer Federstruktur mit einzelnen, parallelen erhitzbaren Bereichen, die federnd gelagert miteinander verbunden sind. Die in Richtung des Deckelements und in Emissionsrichtung orientierten Projektionen der erhitzbaren Bereiche bilden die Emissionsfläche, welche wiederum mit den dazwischenliegenden nicht-erhitzbaren Bereichen bzw. deren Projektionen die Gesamtfläche bilden.

Eine Form- und/oder Strukturänderung durch eine Vergrößerung des MEMS-Heizelements und dessen Gesamtfläche wird durch zwei seitlich vom Heizelement platzierte Aktuatoren in Form von Kammantrieben realisiert, welche direkt mit der Federstruktur des MEMS-Heizelements gekoppelt sind. Die Aktuatoren sind wiederum an jeweils einem Seitenteil des Gehäuses befestigt. Das MEMS-Heizelement ist bevorzugt bis auf die Verbindung mit den Aktuatoren freistehend. Durch einen beidseitig auf die Federstruktur ausgeübte Zugkraft der Aktuatoren kann dieses in eine Streckung verbracht werden, bei dem die Fläche der Projektionen der nicht-erhitzbaren Bereiche bei gleichbleibender Emissionsfläche maximiert wird, was ebenso für die emittierte IR-Strahlung gilt. Es kommt daher ebenso zu einer Maximierung der Gesamtfläche, so dass das Verhältnis der Emissionsfläche zur Gesamtfläche des MEMS-Heizelements und ebenso die emittierte IR-Strahlung minimal wird. Ebenso kann die Federstruktur durch beidseitige Druckkräfte der Aktuatoren in eine Stauchung verbracht werden, in dem das Verhältnis der konstanten Emissionsfläche zur Gesamtfläche maximal ist. Somit kann erreicht werden, dass das Verhältnis der Emissionsfläche zur Gesamtfläche des MEMS-Heizelements in einem ersten Zustand um mindestens einen Faktor 2 geringer ist als in dem zweiten Zustand. Die emittierte IR-Strahlung ist dabei bevorzugt direkt proportional zu dem Flächenverhältnis. Ein solcher IR-Emitter weist eine besonders hohe Modulationsfrequenz und eine besonders exakte Steuerbarkeit der Intensität der emittierten IR-Strahlung auf.

In einem weiteren Ausführungsbeispiel des modulierbaren IR-Emitters weist das MEMS-Heizelement eine Lamellenstruktur mit drehbaren Lamellen, ähnlich einer Jalousie auf, die in einer Rahmenstruktur drehbar gelagert sind, durch die die Gesamtfläche nach außen begrenzt wird. Die Lamellen bilden die erhitzbaren Bereiche. Sind die Lamellen in Emissionsrichtung orientiert, fallen Emissionsfläche und Gesamtfläche im Wesentlichen zusammen. Das Verhältnis der Emissionsfläche zur Gesamtfläche des MEMS-Heizelements und die Intensität in Emissionsrichtung ist maximal. Dies entspricht dem zweiten Zustand. Werden die einzelnen Lamellen in Bezug zur Emissionsrichtung um 90 ° durch mindestens einen Aktuator verdreht, so dass die erhitzbaren Bereiche im Wesentlichen gleichermaßen nicht mehr in diese Richtung zeigen, wird die Emissionsfläche bei im Wesentlichen gleichbleibender Gesamtfläche minimal und ist nun im Wesentlichen identisch mit der Projektion der nicht-erhitzbaren Bereiche. Das Verhältnis der Emissionsfläche zur Gesamtfläche des MEMS-Heizelements ist minimal, ebenso wie die Intensität in Emissionsrichtung (erster Zustand). So wird ebenfalls umgesetzt, dass das Verhältnis der Emissionsfläche zur Gesamtfläche des MEMS-Heizelements in dem ersten Zustand um mindestens einen Faktor 2 geringer ist, als in dem zweiten Zustand.

Es kann dabei bevorzugt sein, dass die Lamellen keine isotrope Emission der IR-Strahlung aufweisen, sondern die Emission bevorzugt in Richtung der Flächennormalen der erhitzbaren Bereiche (Vorderflächen) am Größten ist. Die im zweiten Zustand in Emissionsrichtung ausgerichteten Seiten der Lamellen emittieren somit auch in Bezug auf ihre Fläche weniger IR-Strahlung als die im ersten Zustand in Emissionsrichtung ausgerichteten Vorderflächen. Dadurch sinkt die Intensität beim Übergang vom zweiten in den ersten Zustand im Vergleich zur Änderung des Flächenverhältnisses überproportional und es kann eine besonders hohe Modulationstiefe in dieser Ausführungsform erreicht werden.

Ein solcher, durch die vorstehenden Beispiele illustrierter IR-Emitter weist bevorzugte Eigenschaften auf, er ist schnell modulierbar, die Modulationstiefe ist für viele Anwendungen geeignet. Er ist kompakt, robust und langlebig. Auch die Bandbreite der Modulation ist gegenüber den aus dem Stand der Technik bekannten Modulationsverfahren stark verbessert.

In einer bevorzugten Ausführungsform der Erfindung ist die Intensität der von dem MEMS-Heizelement in die Emissionsrichtung emittierten Infrarotstrahlung in dem ersten Zustand um einen Faktor 2, bevorzugt 4, mehr bevorzugt 6 geringer ist als in dem zweiten Zustand. Die Intensität ist bevorzugt als durchschnittliche Intensität der Infrarotstrahlung über die Gesamtfläche des MEMS-Heizelementes aufzufassen und wird somit bevorzugt aus der Strahlungsenergie pro Gesamtfläche und Zeiteinheit gebildet. Die Modulation der Intensität wird wie vorstehend bereits beschrieben insbesondere dadurch erreicht, dass in einem ersten Zustand das Verhältnis der Emissionsfläche zur Gesamtfläche um mindestens einen Faktor 2, bevorzugt 4 oder 6 geringer ist als in einem zweiten Zustand. Dabei kann sich, je nach Ausführungsform die Intensität um genau den Verhältnisfaktor ändern oder aber um einen größeren Faktor, wenn sich z. B. die pro Flächeneinheit der Emissionsfläche emittierte Intensität der IR-Strahlung ändert. Dies ist bspw. der Fall, wenn das MEMS-Heizelement eine Lamellenstruktur aufweist und die erhitzbaren Bereiche beim Übergang vom zweiten zum ersten Zustand aus der Emissionsrichtung heraus gedreht werden. Somit erlaubt der modulierbare IR-Emitter eine besonders effektive Modulation, da die Modulationstiefe mindestens der Änderung des Flächenverhältnisses entspricht.

Das Verhältnis der durchschnittlichen Intensitäten zwischen zweitem und erstem Zustand wird bevorzugt auch Extinktionsverhältnis genannt. Es ist besonders bevorzugt, dass ein Extinktionsverhältnis von mindestens 2 erreichbar ist. Dieses Verhältnis ist bevorzugt der direkte Quotient zwischen der maximalen und minimalen Intensität. Es kann jedoch auch bevorzugt sein, das höhere Extinktionsverhältnisse von z.B. mindestens 3, 4, 5, 6, 7, 8, 9, 10, 15, 20, 25, 30, 40, 50, 100, 200, 300, 400, 500 oder 1000 möglich sind. Das Extinktionsverhältnis kann ebenso in dB ausgedrückt werden, dabei sind Extinktionsverhältnisse von mindestens 3 dB, mindestens 10 dB, mindestens 20 dB, mindestens 30 dB oder mindestens 40 dB bevorzugt. Durch die bevorzugten Extinktionsverhältnisse lassen sich die gewünschten Anwendungen, z. B. in der photoakustischen Spektroskopie, besonders gut realisieren.

In einer weiteren bevorzugten Ausführungsform der Erfindung umfasst das MEMS-Heizelement eine Federstruktur und der Aktuator ist ein Linearaktuator, welcher für eine Stauchung und/oder Streckung der Federstruktur konfiguriert ist. Diese vorstehend bereits beschriebene Ausführungsform zeichnet sich durch einen besonders kompakten und einfach herzustellenden Aufbau aus, welcher besonders hohe Modulationsfrequenzen erlaubt. Ein Linearaktuator ist bevorzugt ein Aktuator, in dem das Antriebsprinzip direkt in einer linearen Bewegung des Rotors in einer Dimension resultiert. Dies ermöglicht die Ausübung von Druck- bzw. Zugkräften auf die Federstruktur zur Stauchung bzw. Streckung. Dabei kann es bevorzugt sein, die Federstruktur an einem Ende mit dem Gehäuse des IR-Emitters fest zu verbinden und am anderen Ende direkt mit dem Rotor des Aktuators. Ebenso kann, wie vorstehend geschildert, bevorzugt sein, die Federstruktur beidseitig mit den Rotoren zweier Linearaktuatoren zu verbinden. Dadurch kann auch bei kleinen Bewegungen des jeweiligen Aktuators eine große Änderung zwischen Emissionsfläche und Gesamtfläche erreicht werden. So sind überraschend hohe Modulationstiefen bei gleichzeitig hohen Modulationsfrequenzen möglich. Die Federstruktur ist dabei bevorzugt realisiert durch elastische Verbindungen zwischen erhitzbaren Bereichen durch eine federartige Struktur. Hierdurch kann ein besonders einfacher und effektiver Aufbau bereitgestellt werden.

In einer weiteren bevorzugten Ausführungsform umfasst das MEMS-Heizelement eine Lamellenstruktur mit drehbaren Lamellen und der Aktuator ist für eine Drehung der Lamellen konfiguriert. Auch diese Ausführungsform wurde bereits vorstehend beschrieben. Die Lamellen sind dabei drehbar in einer Rahmenstruktur gelagert. Die Lamellen können dabei jeweils über einen eigenen Aktuator gesteuert werden, z. B. über einen elektrostatischen (kapazitiven) oder elektromagnetischen Aktuator. Solche Aktuatoren sind besonders einfach und kompakt zu realisieren, besonders energieeffizient und erlauben eine besonders schnelle Drehung der Lamellen, mithin eine besonders hohe Modulationsfrequenz. Es kann ebenso sein, dass mindestens ein Aktuator in Form eines Elektromotors verwendet wird. Dieser ist besonders gut für Drehbewegungen geeignet und erlaubt eine besonders präzise Ansteuerung der Lamellen, bei der auch Positionen zwischen einer Drehung um 0 ° und 90 ° in Bezug auf die Emissionsrichtung gezielt angesteuert werden können. Durch einen solchen Aktuator können auch mehrere Lamellen gleichzeitig durch bspw. ein Zahnrad oder einen Riemen gedreht werden.

In einer bevorzugten Ausführungsform der Erfindung umfasst das MEMS-Heizelement eine verschränkbare Struktur und der Aktuator ist ein Linearaktuator, welcher für eine Variation der Verschränkung konfiguriert ist. Eine Variation der Verschränkung beschreibt dabei bevorzugt eine Variation der Gesamtfäche und/oder der Emissionsfläche durch eine Änderung des Abstandes der einzelnen, bevorzugt T-förmigen Elemente der Struktur. Das Grundprinzip ist dabei bevorzugt ähnlich zu einer Federsturktur, die verschränkbare Struktur kann durch die Aktuatoren komprimiert (gestaucht) werden, was einem zweiten Zustand entspricht oder auseinandergezogen (gestreckt) werden, was einem ersten Zustand entspricht. Die verschränkbare Struktur wird dabei bevorzugt gebildet durch mehrere T-Stücke, welche in abwechselnder Orientierung nach oben, mit dem Querbalken in Emissionsrichtung, bzw. nach unten angeordnet sind und so in einem komprimierten, zweiten Zustand für eine möglichst kleine Gesamtfläche gut ineinanderpassen. Die erhitzbaren Bereiche werden dabei bevorzugt durch die oberen T-Stücke gebildet, deren Querbalken bevorzugt im Wesentlichen mit der Emissionsfläche zusammenfallen. Die einzelnen T-Stücke sind dabei bevorzugt durch eine elastische Struktur verbunden, welche z. B. federartig strukturiert ist. Ebenso können die T-Stücke bevorzugt auf einer Schiene geeignet bewegbar gelagert werden. Die T-Stücke selber können ebenso bevorzugt Rotoren eines elektrostatischen Aktuators sein.

In einer bevorzugten Ausführungsform weist der Infrarot-Emitter ein Gehäuse auf, in welchem das MEMS-Heizelement und der Aktuator installiert vorliegen.

Das Gehäuse kann sich dabei bevorzugt an den Abmessungen und Formen der installierten Elemente orientieren, es kann ebenso bevorzugt sein, dass das Gehäuse bedeutend größer als die installierten Elemente ist, um die Handhabbarkeit des Emitters zu verbessern und eine robuste Vorrichtung zu schaffen. Beispielsweise können MEMS-Heizelement und Aktuator Abmessungen im (sub-) Mikrometerbereich haben, wobei das Gehäuse Abmessungen im Zentimeterbereich aufweist.

Es kann, wie vorstehend bereits beschrieben, der Aktuator innerhalb des Gehäuses direkt mit dem MEMS-Heizelement gekoppelt sein. Auch ein möglicher genereller Aufbau des Emitters, welcher ein Gehäuse aufweist, wurde in einer obenstehenden, beispielhaften Ausführung bereits beschrieben.

Bevorzugt ist, dass das Gehäuse eine durchgehende Außenfläche aufweist und nach innen geschlossen ist. Im Inneren des Gehäuses liegt insbesondere das MEMS-Heizelement installiert vor. Dadurch kann dieses vor äußeren Einflüssen geschützt werden. Zudem kann gewährleistet werden, dass eine Emission der IR Strahlung nach außen nur durch bevorzugte für IR-Strahlung durchlässige Bereiche des Deckelements erfolgt, während das Gehäuse dies in andere Richtungen verhindert. Der Aktuator kann bevorzugt an einem Seitenteil des Gehäuses befestigt sein.

Es ist bevorzugt, dass das MEMS-Heizelement nicht thermisch isoliert von dem Gehäuse ist, sondern eine nichtstrahlende Wärmeabgabe vom Heizelement an das Gehäuse möglich ist, so dass Wärme vom Heizelement abfließen kann. So kann z. B. ein gewünschtes Gleichgewicht zwischen der erzeugten Wärme durch die stromdurchflossene, erhitzbare Schicht aus leitfähigen Material und der vom Heizelement an die Umgebung abgegebene Wärme hergestellt werden, die gewünschten Strahlungseigenschaften erzeugt werden und/oder die gewünschten Modulationseigenschaften erreicht werden.

Es kann beispielsweise bevorzugt sein, dass die Elemente Gehäuse, MEMS-Heizelement und/oder Aktuator aus demselben Material hergestellt werden und eine ausreichende Wärmeleitung zwischen direkt verbundenen Elementen besteht.

Das Gehäuse kann bevorzugt zur eigenen Wärmeableitung einen Kühlkörper aufweisen.

Es ist wünschenswert, dass das Deckelement, von den anderen Elementen, insbesondere vom Rest des Gehäuses, thermisch entkoppelt wird. Damit ist bevorzugt gemeint, dass durch Verwendung mindestens eines geeigneten Materials an der Verbindung zwischen Deckelement und restlichem Gehäuse durch ein geeignetes Design der Verbindungsstelle (beispielweise kleine Verbindungsfläche und/oder geeignete Dicke der Verbindung) das Deckelement sich nicht wesentlich aufheizt. Ein Aufheizen wird dabei bevorzugt gegenüber einer Temperatur des Deckelements bei ausgeschaltetem MEMS-Heizelement und im thermischen Gleichgewicht beschrieben.

Ebenso kann bevorzugt sein, dass die zur Bestimmung des zeitlichen Verlaufs der Angleichung der Temperatur des Deckelements zum Gehäuse wesentliche Zeitkonstante ausreichend groß ist. Diese kann beispielsweise größer als 1 Minute, bevorzugt größer als 10 Minuten und insbesondere größer als eine Stunde sein.

Ein geeignetes Material an der Verbindungsstelle umfasst bevorzugt die gesamte Verbindungsfläche. Geeignete Materialien beziehen sich dabei insbesondere auf die Wärmeleitfähigkeit der Materialien, ausgedrückt in Watt pro Meter und Kelvin (W/m-K). Bevorzugte Wärmeleitfähigkeiten an der Verbindungsstelle betragen weniger als 10 W/m·K, besonders bevorzugt weniger als 1 W/m·K und insbesondere weniger als 0,1 W/m·K.

Bevorzugt wird an der Verbindungsstelle zwischen Deckelement und restlichem Gehäuse eine Oxidschicht eingebracht, welche die gewünschte thermische Entkopplung bewirkt. Insbesondere ist eine Oxidschicht besonders gut geeignet, bei den für das Gehäuse verwendeten Materialien für eine thermische Entkopplung zu sorgen. Zudem sind diese besonders leicht und kostengünstig zu erzeugen.

Damit die direkte Übertragung von Wärme zwischen MEMS-Heizelement und Gehäuse, insbesondere Deckelement minimiert wird, kann es bevorzugt sein, dass das Gehäuse konfiguriert ist für eine Erzeugung eines Vakuums in einem Zwischenraum zwischen diesen Elementen. Ein Vakuum bezeichnet bevorzugt einen Druck von weniger als 30 x 10³ Pascal (Pa), besonders bevorzugt von weniger als 100 Pa und insbesondere von 0,1 Pa und weniger. Konfiguriert bedeutet, dass das Gehäuse ausreichend druckdicht gestaltet ist. Außerdem ist es bevorzugt, dass das Gehäuse einen Anschluss für eine Vakuumpumpe bzw. eine integrierte Vakuumpumpe aufweist. Es kann aber ebenso bevorzugt bei der Herstellung im Wesentlichen dauerhaft evakuiert werden.

Es kann ebenso bevorzugt sein, dass das Gehäuse und/oder insbesondere das Deckelement gekühlt wird, um eigene Emission von unmodulierter IR-Strahlung in Richtung des modulierten Strahls zu minimieren. Beispielsweise können Peltierelemente und/oder eine Fluidkühlung hierzu verwendet werden.

In einer weiteren bevorzugten Ausführungsform der Erfindung weist das Gehäuse ein Deckelement auf, in welchem zusätzlich mindestens ein optischer Filter installiert vorliegt.

Somit ist der optische Filter bevorzugt in das Gehäuse integriert und liegt an dessen einer äußeren Oberfläche vor, welche durch das Deckelelement des Gehäuses gebildet wird. Der optische Filter kann dabei das Deckelement im Wesentlichen bilden oder von diesem umfasst sein.

Je nach Verwendung des IR-Emitters, z. B. bei verschiedenen Spektroskopiemethoden, kann entweder das gesamte breite Frequenzspektrum der thermischen Strahlungsquelle genutzt werden oder es werden schmalere Spektren erwünscht. Zur Selektion eines gewünschten Spektrums, welches sich von dem emittierten Spektrum des MEMS-Heizelements deutlich unterscheidet, können bevorzugt Frequenzfilter verwendet werden. Diese sind vorteilhafterweise in das Deckelement integriert.

Die verwendeten Filter können vorteilhafterweise verschiedene Filtereigenschaften aufweisen, z. B. können Bandpassfilter, Kurzpassfilter, Langpassfilter, Kerbfilter (engl. "Notchfilter") und jede beliebige Kombination dieser Filter, die zu den gewünschten spektralen Beeinflussungen führen, verwendet werden. Die Frequenzen bzw. Frequenzbereiche, in denen die Filter wirken, können beliebig je nach Anwendung gewählt werden.

Als Filter kann beispielsweise ein Filterrad zum Einsatz kommen, auf dem Filter mit verschiedenen Filtereigenschaften eingebaut sind. So kann mechanisch, durch Drehung des Filterrads, der gewünschte Filter ausgewählt werden. Dabei kann das Filterrad bevorzugt durch einen elektrischen Antrieb gedreht werden.

Ebenso ist die Verwendung eines Fabry-Perot Filters denkbar. Ein solcher Filter kann beispielsweise zur Selektion sehr schmaler Spektren verwendet werden. Bevorzugt ist das dem Filter zur Grunde liegende Fabry-Perot Interferometer durchstimmbar, beispielsweise durch eine Abstimmbarkeit der Temperatur oder durch mechanische Anpassung. So können flexibel gewünschte Spektren aus dem Ursprungsstrahl selektiert werden.

Ebenso können vorzugsweise geeignete Dünnschichtfilter verwendet werden. Diese sind besonders einfach herzustellen und sind sehr kompakt. Insbesondere bei einer Herstellung des IR-Emitters in integrierter Bauweise in einem Herstellungsprozess kann die Herstellung eines solchen Dünnschichtfilters einfach in den Prozess integriert werden. Hierdurch werden die Kosten gesenkt.

Auch eine flexible Kombination von Dünnschichtfiltern bzw. ein durch z. B. Verfahren der Temperatur abstimmbarer Dünnschichtfilter ist vorteilhaft.

Es können auch Filter für andere Eigenschaften der IR-Strahlung, z. B der Polarisation, verwendet werden, welche bevorzugt ebenfalls Teil des Deckelements sind.

In einer weiteren bevorzugten Ausführungsform der Erfindung umfasst das MEMS-Heizelement ein Substrat, auf welchem mindestens teilweise eine erhitzbare Schicht aus einem leitfähigen Material aufgebracht ist, an welchem Kontakte für eine Strom- und/oder Spannungsquelle vorliegen.

Das Substrat bildet bevorzugt die Basis des MEMS-Heizelements und kann in geeigneter Weise strukturiert werden, z. B. für eine Federstruktur. Dabei kann das Substrat auch weitere Elemente des IR-Emitters, wie beispielsweise den Aktuator und/oder Gehäuseelemente zumindest teilweise umfassen. Das Substrat kann vorteilhafterweise durch etablierte Prozessschritte, insbesondere aus der Halbleiter- und/oder Mikrosystemherstellung, geeignet geformt werden. Dann kann bevorzugt eine erhitzbare Schicht aus einem leitfähigen Material auf das Substrat aufgebracht bzw. in das Substrat integriert werden, z. B. durch Dotierung und/oder Beschichtung. Diese erhitzbare Schicht umfasst bevorzugt die erhitzbaren Bereiche des MEMS-Heizelements. Es ist bevorzugt, dass die erhitzbare Schicht zur Herstellung eines elektrischen Kontakts mit einer Quelle elektrischer Energie kontaktiert wird. Die Kontaktierung ist in erster Linie so vorzunehmen, dass die erhitzbaren Bereiche zumindest teilweise von elektrischem Strom durchflossen werden und in gewünschter Weise IR-Strahlung aussenden.

In einer weiteren bevorzugten Ausführungsform des modulierbaren Infrarot-Emitters ist das Substrat ausgewählt aus einer Gruppe umfassend Silizium, monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid und/oder Indiumphosphid. Diese Materialien sind in der Halbleiter- und/oder Mikrosystemherstellung besonders einfach und kostengünstig zu bearbeiten und eignen sich ebenfalls gut für eine Massenherstellung. Ebenso sind diese Materialien für ein Dotieren und/oder Beschichten besonders geeignet, um in bestimmten Bereichen die gewünschten elektrischen, thermischen und/oder Strahlungseigenschaften zu erzielen.

In einer weiteren bevorzugten Ausführungsform des modulierbaren Infrarot-Emitters ist das leitfähige Material zur Bildung der erhitzbaren Schicht ausgewählt aus der Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit und/oder Kupfer. Diese Materialien weisen zum einen die gewünschten thermischen, elektrischen, mechanischen und/oder Strahlungseigenschaften auf und sind darüber hinaus besonders leicht und kostengünstig zu verarbeiten.

In einer bevorzugten Ausführungsform ist der Aktuator ein MEMS-Aktuator, bevorzugt ausgewählt aus der Gruppe umfassend elektrostatischer Aktuator, piezoelektrischer Aktuator, elektromagnetischer Aktuator und/oder thermischer Aktuator.

Ein MEMS-Aktuator ist bevorzugt ein Aktuator, der mithilfe von üblichen Herstellungsmethoden der Mikrosystemtechnik hergestellt wird und des Weiteren vorteilhafterweise Abmessungen in der Größenordnung µm aufweist. Ein solcher Aktuator ist besonders kompakt, robust und wartungsarm und lässt sich einfach und kostengünstig herstellen. Insbesondere können große Teile des Emitters MEMS-Elemente, das heißt Elemente mit den bevorzugten, vorstehend genannten Eigenschaften sein und in einem Herstellungsschritt mit dem MEMS-Aktuator herstellbar sein. Es kann wünschenswerterweise in Teilen das gleiche Substrat zur Herstellung verwendet werden. Dies vereinfacht und verbilligt die Herstellung.

Die vorstehend genannten Aktuatoren sind besonders gut für eine große Anzahl schneller, periodischer Bewegungen geeignet und weisen insbesondere aufgrund des kompakten Aufbaus einen geringen Energiebedarf auf. Auch ist die Bandbreite der erzielbaren Bewegungsgeschwindigkeiten aufgrund des kompakten Aufbaus, geringer Trägheiten und der bevorzugten Linearbewegung sehr hoch.

Für die Modulation kann eine möglichst gute Ableitung der Wärme vom MEMS-Heizelement über den bevorzugt gekoppelten Aktuator an das bevorzugte Gehäuse wünschenswert sein. Daher kann es bevorzugt sein, dass der Aktuator im Wesentlichen oder teilweise aus dem Gehäusematerial gefertigt ist.

In einer weiteren bevorzugten Ausführungsform des modulierbaren Infrarot-Emitters ist der MEMS-Aktuator ein elektrostatischer Aktuator in Form eines Kammantriebs basierend auf einer Variation der Kammüberdeckung und/oder des Kammabstands.

MEMS-Kammantriebe sind aus dem Stand der Technik bekannt, z. B. aus der Patentanmeldung DE 10 2017 206 183 A1. Dabei kann je nach Ausführungsform die Kammüberdeckung und/oder der Kammabstand variiert werden.

Es hat sich gezeigt, dass solche MEMS-Kammantriebe aufgrund ihrer Abmessungen und der erzeugbaren Bewegungen besonders geeignet sind für eine bevorzugte Linearbewegung und einen kompakten IR-Emitter.

In einem weiteren Aspekt betrifft die Erfindung ein Herstellungsverfahren für einen Infrarot-Emitter wie vorstehend beschrieben, wobei die Herstellung des MEMS-Heizelementes folgende Schritte umfasst:
- Ätzen des Substrats;
- Abscheiden eines leitfähigen Materials;
- Vorzugsweise Strukturierung des Substrats zu einem MEMS-Heizelement und/oder des leitfähigen Materials zu einer erhitzbaren Schicht;
- Kontaktierung des leitfähigen Materials.

Als Substrat kann z. B. eines der bevorzugten, vorstehend genannten Materialien verwendet werden. Beim Ätzen kann ein Rohling, beispielsweise ein Wafer, in die gewünschte Grundform des MEMS-Heizelements gebracht werden. In einem nächsten Schritt wird das leitfähige Material für die erhitzbare Schicht abgeschieden. Dabei sollen insbesondere die erhitzbaren Bereiche umfasst sein.

Sollte eine weitere Strukturierung des MEMS-Heizelements, bspw. zu einer Federstruktur und/oder des leitfähigen Materials gewünscht sein, kann dies z. B. durch weitere Ätzprozesse vorgenommen werden. Ebenso kann zusätzliches Material abgeschieden werden oder eine Dotierung durch übliche Verfahren vorgenommen werden.

Zur Kontaktierung des leitfähigen Materials kann zusätzlich geeignetes Material, wie z. B. Kupfer, Gold und/oder Platin auf dem leitfähigen Material durch gängige Prozesse abgeschieden werden. Hierfür können bevorzugt physikalische Gasphasenabscheidung (PVD), chemische Gasphasenabscheidung (CVD) oder elektrochemische Abscheidung zum Einsatz kommen.

Auf diese Weise kann ein besonders fein strukturierte MEMS-Heizelement hergestellt werden, welches bevorzugt Abmessungen im Mikrometerbereich sowie die gewünschten funktionellen Eigenschaften hat. Ebenso haben sich diese Herstellungsschritte besonders bewährt und gehören zu Standardverfahrensschritten der Halbleiterprozessierung.

In einer weiteren bevorzugten Ausführungsform der Erfindung ist ein Ätzen und/oder eine Strukturierung ausgesucht aus der Gruppe umfassend Trockenätzen, nasschemisches Ätzen und/oder Plasmaätzen, insbesondere Reaktives lonenätzen, Reaktives lonentiefenätzen (Bosch-Prozess); und/oder das Abscheiden ausgesucht ist aus der Gruppe umfassend physikalische Gasphasenabscheidung (PVD), insbesondere thermisches Verdampfen, Laserstrahlverdampfen, Lichtbogenverdampfen, Molekularstrahlepitaxie, Sputtern, chemische Gasphasenabscheidung (CVD) und/oder Atomlagenabscheidung (ALD).

Diese Verfahren sind für die Herstellung von feinen Strukturen mit Größenordnungen im Mikrometerbereich besonders geeignet. Insbesondere durch den Boschprozess können sehr feine Strukturen mit hohem Aspektverhältnis erzeugt werden, die für ein funktionelles, kompaktes, effizientes und bevorzugt in den restlichen Aufbau des Emitters vollintegriertes MEMS-Heizelement von Vorteil sind.

In einem weiteren Aspekt betrifft die Erfindung ein System umfassend
- einen modulierbarer Infrarot-Emitter gemäß der vorhergehenden Beschreibung
- eine Steuereinrichtung
wobei die Steuereinrichtung konfiguriert ist zur Regulation des Aktuators zur Änderung der Form und/oder Struktur des MEMS-Heizelementes zwischen einem ersten und zweiten Zustand, sodass das Verhältnis der Emissionsfläche zur Gesamtfläche des MEMS-Heizelements in dem ersten Zustand um einen Faktor 2 geringer ist, als in dem zweiten Zustand.

Die Steuereinrichtung ermöglicht bevorzugt eine Eingabe und setzt diese Eingabe in geeignete Steuersignale um. Eine Eingabe kann beispielsweise ein gewünschtes Spektrum, eine gewünschte Intensität und/oder Modulationsfrequenz sein. Die Steuereinrichtung erzeugt dann in erster Linie entsprechende analoge elektrische Signale, welche an den Aktuator und/oder das MEMS-Heizelement weitergegeben werden, um die gewünschte IR-Strahlung zu erzeugen.

Es können aber auch komplexere Signale als Eingabe dienen, welche einen genauen zeitlichen Amplitudenverlauf der ausgehenden IR-Strahlung für ein gewünschtes Spektrum vorgeben. Die Steuereinrichtung sorgt dann ebenfalls bevorzugt für die geeigneten Steuersignale zur Erzeugung der gewünschten, modulierten IR-Strahlung.

Die Steuereinrichtung ist insbesondere konfiguriert für eine Regulation des Aktuators zur Änderung der Form und/oder Struktur des MEMS-Heizelementes zwischen einem ersten und zweiten Zustand. Dafür werden elektrische Signale erzeugt, die die erforderliche Bewegung des Aktuators auslösen.

Bevorzugt umfasst die Steuereinrichtung eine Regelschleife, wobei durch einen Feedbackmechanismus eine Diskrepanz zwischen gewünschter Steuerung und tatsächlicher Bewegung des Aktuators und/oder Erhitzung des MEMS-Heizelements korrigiert werden kann.

Es kann bevorzugt sein, dass ebenfalls der Temperaturverlauf des MEMS-Heizelements zur zusätzlichen, langsamen Modulation der IR-Strahlung durch die Steuereinrichtung geregelt werden kann.

Die Steuereinrichtung des Systems kann sowohl extern als auch auf dem IR-Emitter integriert vorliegen.

Die Steuereinrichtung umfasst bevorzugt einen Prozessor, beispielsweise einen Mikroprozessor. Es können auch andere integrierte Schaltungen, welche in der digitalen Elektronik zur Steuerung verwendet werden, zum Einsatz kommen.

Die Verwendung eines solchen Systems umfassend eine geeignete Steuereinrichtung kann die gewünschte Verwendung des IR-Emitters erheblich vereinfachen. Beispielsweise können geeignete Spektroskopiesignale am PC gestaltet werden. Über die Eingabe werden die gewünschten Signale dann an die Steuereinrichtung übertragen. Von dieser werden dann die Ansteuerungssignale erzeugt, welche ein entsprechendes IR-Signal in hoher Übereinstimmung mit den theoretischen Vorgaben erzeugt.

Eine Steuereinrichtung, insbesondere in Form einer in den Emitter integrierten Steuerung, ist sehr kompakt und einfach zu handhaben. Die Steuereinrichtung weist für die Eingabe bevorzugt eine geeignete Schnittstelle zur Verbindung bspw. mit einem Computer auf. Es kann ebenso gewünscht sein, dass über diese Schnittstelle auch Daten von der Steuerung an das Eingabegerät übertragbar sind, wie beispielsweise die aktuelle Temperatur des Heizelements oder andere Statusinformationen.

In einer weiteren bevorzugten Ausführungsform des Systems ist die Steuereinrichtung konfiguriert zur Regulation der Temperatur der erhitzbaren Bereiche des MEMS-Heizelements, bevorzugt in einem Bereich zwischen 50 °C und 1000 °C.

Eine solche Steuereinrichtung ist bevorzugt in der Lage, dem MEMS-Heizelement geeignete elektrische Leistungen zur Verfügung zu stellen. Insbesondere soll die Temperatur hinreichend genau einstellbar sein und/oder konstant gehalten werden können. Dafür kann ein Regelmechanismus mit einer Feedbackschleife verwendet werden. Zur Messung der aktuellen Temperatur des MEMS-Heizelements kann z. B. mindestens ein Temperatursensor an geeigneter Stelle des Elements integriert sein.

Durch eine solche Steuereinrichtung lässt sich das Spektrum und/oder die Intensität des IR-Emitters besonders einfach und zuverlässig steuern.

In einer weiteren bevorzugten Ausführungsform ist die Steuereinrichtung konfiguriert, den Aktuator für eine oszillierende Zustandsänderung der Form und/oder Struktur des Heizelementes zu regulieren.

Bevorzugt ist, dass die vom Aktuator ausgelöste Änderung der Form und/oder Struktur des MEMS-Heizelementes zwischen einem ersten und zweiten Zustand regelmäßig wiederholt wird, so dass es zu einer Oszillation zwischen den Zuständen kommt und die Änderung eine Periodizität aufweist. Dabei soll am Ende der Form und/oder Strukturänderung bevorzugt wieder der Anfangspunkt der Bewegung erreicht werden und die Bewegung in der darauffolgenden Periode von Neuem ausgeführt werden. Die Wiederholfrequenz ergibt dabei bevorzugt die resultierende Modulationsfrequenz.

Es kann auch eine im Rahmen der elektronischen Auflösung und/oder Bandbreite der Steuerungseinrichtung und/oder des Aktuators stufenlose Einstellung der Modulationsfrequenz vorgenommen werden. Somit kann die Modulationsfrequenz bevorzugt im zeitlichen Verlauf variiert werden.

Dadurch ergibt sich ein System, durch das sehr flexibel und effizient eine Modulationsfrequenz der IR-Strahlung eingestellt und variiert werden kann.

In einer weiteren bevorzugten Ausführungsform des Systems ist die Steuereinrichtung konfiguriert ist, den Aktuator für eine oszillierende Zustandsänderung der Form und/oder Struktur des Heizelementes zu regulieren, sodass eine Modulationsfrequenz der Leistungsintensität der emittierten Infrarotstrahlung zwischen 10 Hz und 100 kHz erreicht wird.

Hierfür ist besonders bevorzugt, dass alle benötigten Bauteile, wie Steuerungseinrichtung, MEMS-Heizelement, Aktuator etc., die benötigte Bandbreite ermöglichen.

Die genannten Frequenzen haben sich für die bevorzugten Anwendungen im Bereich der Spektroskopie als besonders wirksam erwiesen. Insbesondere zur Verwendung in der photoakustischen Spektroskopie haben sich diese Frequenzen als besonders geeignet erwiesen, da sie einen großen Bereich akustischer Frequenzen abdecken, deren Erzeugung bei dieser Spektroskopiemethode im Vordergrund steht.

In einem weiteren Aspekt betrifft die Erfindung ein Verfahren zur modulierten Emission von Infrarotstrahlung umfassend
- Bereitstellen eines modulierbarer Infrarot-Emitter gemäß einem der vorstehenden Beschreibung;
- Erhitzen der erhitzbaren Bereiche des MEMS-Heizelementes zur Emission einer Infrarotstrahlung;
- Steuerung des Aktuators zur Änderung der Form und/oder Struktur des MEMS-Heizelementes zwischen einem ersten und zweiten Zustand, sodass das Verhältnis der Emissionsfläche zur Gesamtfläche des MEMS-Heizelements in dem ersten Zustand um mindestens einen Faktor 2 geringer ist, als in dem zweiten Zustand.

Der durchschnittliche Fachmann erkennt, dass technische Merkmale, Definitionen und Vorteile bevorzugter Ausführungsformen des erfindungsgemäßen IR-Emitters und des Systems auch für das erfindungsgemäße Verfahren gelten.

In einem weiteren Aspekt betrifft die Erfindung die Verwendung eines modulierbaren Infrarot-Emitters gemäß der vorstehenden Beschreibung oder eines Systems gemäß der vorstehenden Beschreibung für die photoakustische Spektroskopie und/oder Infrarotspektroskopie.

Insbesondere in der Infrarotspektroskopie kann der beschriebene IR-Emitter verwendet werden. Ein kompakter, langlebiger IR-Emitter, der ein breites Spektrum aufweist und modulierbar ist, ist für eine Vielzahl von Anwendungen interessant.

Beispielsweise können durch zeitaufgelöste Messungen bestimmte Frequenzbereiche des IR-Emitters selektiert werden, indem durch einen durchstimmbaren Filter zu verschiedenen Zeiten verschiedene Frequenzen des Spektrums des Emitters selektiert werden. Durch die Modulation können hiervon wiederum bestimmte Frequenzen moduliert werden, so dass IR-Pulse mit im Wesentlichen wohldefinierten Frequenzen emittiert werden. Dadurch kann bei einer zeitaufgelösten Aufnahme, z. B. eines Absorptionsspektrums, die jeweils absorbierte Frequenz genau bestimmt werden.

Auch die Verwendung eines kompakten, langlebigen und hochfrequent modulierbaren IR-Emitters in der photoakustischen Spektroskopie ist von Vorteil. Gerade für die photoakustische Spektroskopie sind viele Anwendungen denkbar, die nicht im Labor stattfinden und unter Alltagsbedingungen funktionieren müssen. Zu nennen sind beispielsweise militärische Anwendungen zur Detektion von Giftgas oder die Detektion von (Schad-) Stoffen in der Umgebungsluft. Durch die hohen Modulationsfrequenzen können gegenüber einer direkten Modulation des Heizelements bessere Signal-zu-Rauschverhältnisse erzielt werden, außerdem ist ein nicht direkt modulierter Emitter langlebiger.

In einem weiteren Aspekt betrifft die Erfindung ein photoakustisches Spektroskop zur Analyse von Gas, umfassend
- einen modulierbaren Infrarot-Emitter gemäß einem der vorstehenden Beschreibung
- ein mit Gas befüllbares Analysevolumen und
- einen Schalldetektor,
wobei das Analysevolumen zwischen dem Infrarot-Emitter und dem Schalldetektor angeordnet ist, sodass die von dem Infrarot-Emitter modulierbar emittierte Infrarotstrahlung zur photoakustischen Spektroskopie des Gases genutzt werden kann.

Dem Fachmann ist bekannt, wie die photoakustische Spektroskopie durchgeführt wird und welche Komponenten dabei Verwendung finden. Aufgrund des aus dem Stand der Technik nicht bekannten, kompakten und langlebigen IR-Emitters kann der ganze Aufbau besonders kompakt und alltagstauglich hergestellt werden. Durch die hohen Modulationsfrequenzen sind die Analysemöglichkeiten äußerst vielfältig, gleichzeitig kann das Signal-zu-Rauschverhältnis erhöht werden, dass sich bei einem Schalldetektor mit höheren Frequenzen verbessert. Ein typisches 1/f Rauschen kann so beispielsweise verringert werden.

### Detaillierte Beschreibung

Im Folgenden soll die Erfindung an Hand von Beispielen und Figuren näher erläutert werden, ohne auf diese beschränkt zu sein.

### Kurzbeschreibunq der Abbildungen

**Figur 1** zeigt eine schematische Darstellung des IR-Emitters.
**Figur 2** zeigt eine schematische Darstellung des IR-Emitters mit Federstruktur in einem zweiten Zustand.
**Figur 3** zeigt eine schematische Darstellung des IR-Emitters mit Federstruktur in einem ersten Zustand.
**Figur 4** zeigt eine schematische Darstellung des IR-Emitters mit einer verschränkbaren Struktur.
**Figur 5** zeigt eine schematische Darstellung des IR-Emitters mit einer Lamellenstruktur in einem zweiten Zustand.
**Figur 6** zeigt eine schematische Darstellung des IR-Emitters mit einer Lamellenstruktur in einem ersten Zustand.

### Detaillierte Beschreibung der Abbildung

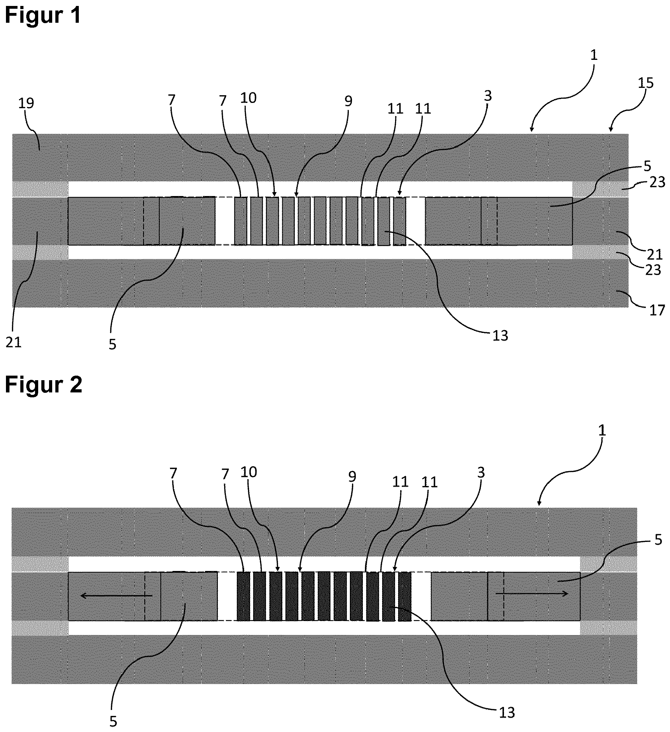

Figur 1 zeigt eine schematische Darstellung des modulierbaren Infrarot-Emitters **1** im Querschnitt. Dieser ist in einem Gehäuse **15** untergebracht, welches aus einem unteren Träger **17,** aus Seitenteilen **21** und aus einem Deckelement **19** besteht. Zwischen Träger **17,** Deckelement **19** und Seitenteilen **21** können jeweils Dichtelemente **23** vorliegen. Diese Dichtelemente **23** werden verwendet, um einen thermischen Austausch des Innern des Emitters **1,** in dem das MEMS-Heizelement **3** vorliegt, mit der äußeren Umgebung des IR-Emitters 1 zu reduzieren. Das MEMS-Heizelement **3** innerhalb des Gehäuses **15** besteht aus einer Federstruktur **13** mit einzelnen, parallelen, erhitzbaren Bereichen **7.** Die in Richtung des Deckelements **19** und in Emissionsrichtung orientierten Projektionen der erhitzbaren Bereiche bilden die Emissionsfläche **10,** welche wiederum mit den dazwischenliegenden nicht-erhitzbaren Bereiche **11** die Gesamtfläche **9** bilden.

Eine Vergrößerung der Gesamtfläche **9** des MEMS-Heizelements **3** der Relativbewegung zwischen Heizelement **3** und Blendenstruktur **3** wird durch zwei seitlich vom Heizelement **3** platzierte Aktuatoren **5** in Form von Kammantrieben realisiert, welche direkt mit der Federstruktur **13** des MEMS-Heizelements **3** gekoppelt ist. Die Aktuatoren **5** sind wiederum an jeweils einem Seitenteil **21** des Gehäuses **15** befestigt. Das MEMS-Heizelement **3** ist bis auf die Verbindung mit den Aktuatoren **5** freistehend.

Figur 2 zeigt den modulierbaren Infrarot-Emitter **1** aus Figur 1 in einem zweiten Zustand, in dem das Verhältnis der Emissionsfläche **10** zur Gesamtfläche **9** maximal ist, da sich die Federstruktur **13** durch die Aktuatoren **5** in einem gestauchten Zustand befindet, in dem die Fläche der nicht-erhitzbaren Bereiche **11** minimiert wird und somit auch die Gesamtfläche **9,** die sich aus der Emissionsfläche **10** und den nicht erhitzbaren Bereichen **11** zusammensetzt. In dieser Ausführungsform bleibt die Emissionsfläche **10** unverändert. Das Verhältnis zwischen Emissionsfläche **10** und Gesamtfläche **9** ist in dem zweiten Zustand maximal. Dies gilt auch für Intensität der emittierten Infrarot-Strahlung.

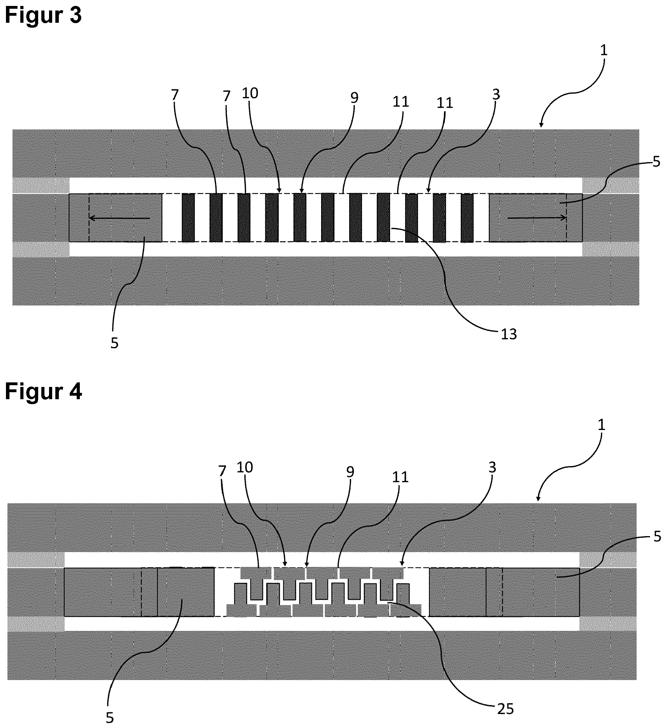

Figur 3 zeigt den modulierbaren Infrarot-Emitter **1** aus den Figuren 1 und 2 in einem ersten Zustand, bei dem die emittierte Strahlung eine minimale Intensität aufweist. Hier wird die Federstruktur **13** durch die Aktuatoren **5** in einen gestreckten Zustand verbracht, bei dem die Fläche der nicht- erhitzbaren Bereiche **11** bei gleichbleibender Emissionsfläche **10** maximiert wird. Es kommt daher ebenso zu einer Maximierung der Gesamtfläche **9,** so dass das Verhältnis der Emissionsfläche **10** zur Gesamtfläche des MEMS-Heizelements minimal und um mindestens einen Faktor 2 geringer ist als in dem zweiten Zustand. Die Intensität der emittierten Infrarot-Strahlung ist in diesem Zustand ebenfalls minimal.

Figur 4 zeigt eine alternative Ausführungsform des modulierbaren IR-Emitters **1,** bei dem das MEMS-Heizelement **3** eine verschränkbare Struktur **25** anstelle der Federstruktur aufweist. Das Grundprinzip ist dabei ähnlich, die verschränkbare Struktur **25** kann dabei durch die Aktuatoren **5** komprimiert werden, was einem zweiten Zustand entspricht oder auseinandergezogen werden, was einem zweiten Zustand entspricht. Die verschränkbare Struktur **25** wird dabei gebildet durch mehrere T-Stücke, welche in abwechselnder Orientierung nach oben bzw. unten angeordnet sind und so in einem komprimierten, zweiten Zustand für eine möglichst kleine Gesamtfläche **9** ineinanderpassen. Die erhitzbaren Bereiche **7** können dabei bevorzugt durch die oberen T-Stücke gebildet, deren Querbalken bevorzugt im Wesentlichen mit der Emissionsfläche **10** zusammenfallen. Die einzelnen T-Stücke der Struktur können bevorzugt durch eine elastische Struktur miteinander verbunden sein.

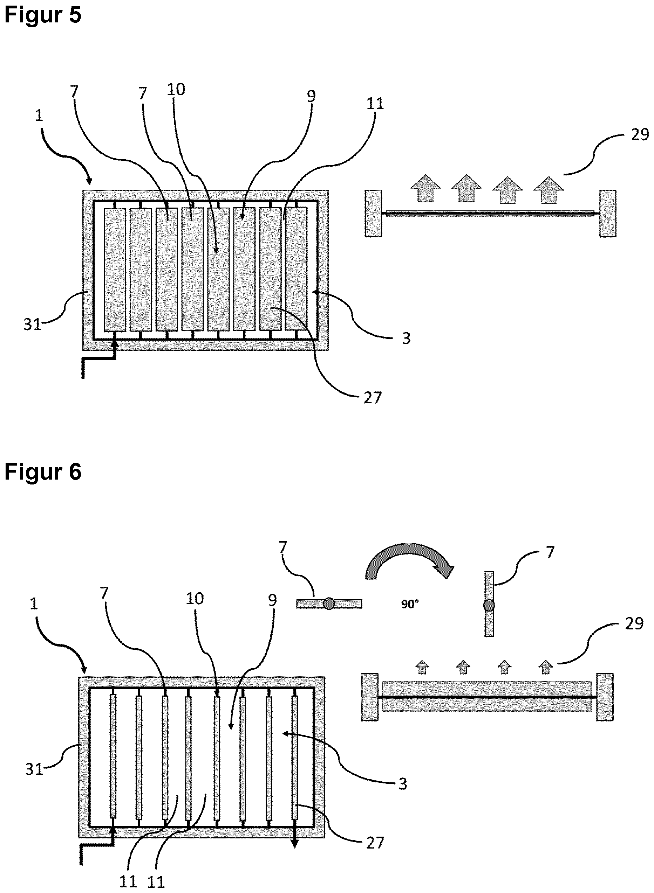

Figur 5 zeigt eine weitere Ausführungsform des modulierbaren IR-Emitters **1,** wobei das MEMS-Heizelement **3** eine Lamellenstruktur **27** mit drehbaren Lamellen aufweist. Die Lamellen bilden die erhitzbaren Bereiche **7** und sind drehbar in einer Rahmenstruktur **31** gelagert. Gezeigt ist ein zweiter Zustand, in dem erhitzbare Bereiche **7,** Emissionsfläche **10** und Gesamtfläche **9** im Wesentlichen zusammenfallen. Das Verhältnis der Emissionsfläche **10** zur Gesamtfläche des MEMS-Heizelements und die Intensität in Emissionsrichtung **29** ist maximal.

Figur 6 zeigt die gleiche Ausführungsform des modulierbaren Infrarot-Emitters **1** in einem ersten Zustand. Hier liegen die einzelnen Lamellen in Bezug zur Emissionsrichtung durch bevorzugt einen Aktuator um 90 ° verdreht vor, so dass die erhitzbaren Bereiche **7** gleichermaßen nicht mehr in diese Richtung zeigen. Die Emissionsfläche **10** wird minimal, die Gesamtfläche **9** ist nun im Wesentlichen identisch mit den nicht-erhitzbaren Bereichen **11.** Das Verhältnis der Emissionsfläche **10** zur Gesamtfläche des MEMS-Heizelements ist minimal, ebenso wie die Intensität in Emissionsrichtung. So wird ebenfalls umgesetzt, dass das Verhältnis der Emissionsfläche **10** zur Gesamtfläche des MEMS-Heizelements in dem ersten Zustand um mindestens einen Faktor 2 geringer ist, als in dem zweiten Zustand.

Es wird darauf hingewiesen, dass verschiedene Alternativen zu den beschriebenen Ausführungsformen der Erfindung verwendet werden können, um die Erfindung auszuführen und zu der erfindungsgemäßen Lösung zu gelangen. Der erfindungsgemäße Infrarotemitter, das System sowie Verfahren und Verwendung dieser beschränken sich in ihren Ausführungen somit nicht auf die vorstehenden bevorzugten Ausführungsformen. Vielmehr ist eine Vielzahl von Ausgestaltungsvarianten denkbar, welche von der dargestellten Lösung abweichen können. Ziel der Ansprüche ist es, den Schutzumfang der Erfindung zu definieren. Der Schutzumfang der Ansprüche ist darauf gerichtet, den erfindungsgemäßen Infrarotemitter, das System, Verfahren deren Verwendung sowie äquivalente Ausführungsformen von diesen abzudecken.

### Bezugszeichenliste

- 1: modulierbarer Infrarotemitter
- 3: MEMS-Heizelement
- 5: Aktuator
- 7: erhitzbare Bereiche
- 9: Gesamtfläche
- 10: Emissionsfläche
- 11: nicht-erhitzbare Bereiche
- 13: Federstruktur
- 15: Gehäuse
- 17: Träger
- 19: Deckelement
- 21: Seitenteile
- 23: Dichtelemente
- 25: verschränkbare Struktur
- 27: Lamellenstruktur
- 29: Intensität in Emissionsrichtung
- 31: Rahmenstruktur

## Patentansprüche

1. Modulierbarer Infrarot-Emitter (1) umfassend
- ein Heizelement und
- einen Aktuator (5)
**dadurch gekennzeichnet, dass**
das Heizelement ein MEMS-Heizelement (3) ist, umfassend erhitzbare Bereiche (7) zur Emission von Infrarotstrahlung in eine Emissionsrichtung, wobei die Projektion der erhitzbaren Bereiche (7) in Emissionsrichtung eine Emissionsfläche (10) und die von dem MEMS-Heizelement (3) aufgespannte Fläche eine Gesamtfläche (9) bilden und der Aktuator (5) konfiguriert ist, die Form und/oder Struktur des MEMS-Heizelementes (3) zwischen einem ersten und zweiten Zustand zu ändern, sodass das Verhältnis der Emissionsfläche zur Gesamtfläche (9) des MEMS-Heizelements (3) in dem ersten Zustand um mindestens einen Faktor 2 geringer ist, als in dem zweiten Zustand.

2. Modulierbarer Infrarot-Emitter (1) nach Anspruch 1,
**dadurch gekennzeichnet, dass**
die Intensität der von dem MEMS-Heizelement (1) in die Emissionsrichtung (29) emittierten Infrarotstrahlung in dem ersten Zustand um einen Faktor 2, bevorzugt 4, mehr bevorzugt 6 geringer ist als in dem zweiten Zustand.

3. Modulierbarer Infrarot-Emitter (1) nach einem oder mehreren der vorherigen Ansprüche,
**dadurch gekennzeichnet, dass**
das MEMS-Heizelement (3) eine Federstruktur (13) umfasst und der Aktuator (5) ein Linearaktuator ist, welcher für eine Stauchung und/oder Streckung der Federstruktur (13) konfiguriert ist.

4. Modulierbarer Infrarot-Emitter (1) nach einem oder mehreren der vorherigen Ansprüche,
**dadurch gekennzeichnet, dass**
das MEMS-Heizelement (3) eine Lamellenstruktur (27) mit drehbaren Lamellen umfasst und der Aktuator (5) für eine Drehung der Lamellen konfiguriert ist.

5. Modulierbarer Infrarot-Emitter (1) nach einem oder mehreren der vorherigen Ansprüche,
**dadurch gekennzeichnet, dass**
das MEMS-Heizelement (3) eine verschränkbare Struktur (25) umfasst und der Aktuator (5) ein Linearaktuator ist, welcher für eine Variation der Verschränkung konfiguriert ist.

6. Modulierbarer Infrarot-Emitter (1) nach einem oder mehreren der vorherigen Ansprüche,
**dadurch gekennzeichnet, dass**
der Infrarot-Emitter ein Gehäuse (15) aufweist, in welchem das MEMS-Heizelement (3) und der Aktuator (5) installiert vorliegen, wobei das Gehäuse (15) bevorzugt ein Deckelement (19) aufweist in welchem zusätzlich mindestens ein optischer Filter installiert vorliegt.

7. Modulierbarer Infrarot-Emitter (1) nach einem oder mehreren der vorherigen Ansprüche,
**dadurch gekennzeichnet, dass**
das MEMS-Heizelement (3) ein Substrat umfasst, auf welchem mindestens teilweise eine erhitzbare Schicht aus einem leitfähigen Material aufgebracht ist, an welchem Kontakte für eine Strom- und/oder Spannungsquelle vorliegen,
wobei das Substrat bevorzugt ausgewählt ist aus einer Gruppe umfassend Silizium, monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid und/oder Indiumphosphid und/oder das leitfähige Material zur Bildung der erhitzbaren Schicht bevorzugt ausgewählt ist aus einer Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit und/oder Kupfer.

8. Modulierbarer Infrarot-Emitter (1) nach einem oder mehreren der vorherigen Ansprüche,
**dadurch gekennzeichnet, dass**
der Aktuator (5) ein MEMS-Aktuator ist, bevorzugt ausgewählt aus der Gruppe umfassend elektrostatischer Aktuator, piezoelektrischer Aktuator, elektromagnetischer Aktuator und/oder thermischer Aktuator,
wobei der Aktuator (5) besonders bevorzugt ein elektrostatischer Aktuator in Form eines Kammantriebs ist basierend auf einer Variation der Kammüberdeckung und/oder des Kammabstands.

9. Herstellungsverfahren für einen Infrarot-Emitter (1) nach einem oder mehreren der vorherigen Ansprüche,
**dadurch gekennzeichnet, dass**
die Herstellung des MEMS-Heizelementes (3) folgende Schritte umfasst:
- Ätzen des Substrats;
- Abscheiden eines leitfähigen Materials;
- Vorzugsweise Strukturierung des Substrats zu einem MEMS-Heizelement (3) und/oder des leitfähigen Materials zu einer erhitzbaren Schicht;
- Kontaktierung des leitfähigen Materials.

10. Herstellungsverfahren nach dem vorherigen Anspruch,
**dadurch gekennzeichnet, dass**
ein Ätzen und/oder eine Strukturierung ausgesucht ist aus der Gruppe umfassend Trockenätzen, nasschemisches Ätzen und/oder Plasmaätzen, insbesondere Reaktives lonenätzen, Reaktives lonentiefenätzen (Bosch-Prozess); und/oder
das Abscheiden ausgesucht ist aus der Gruppe umfassend physikalische Gasphasenabscheidung (PVD), insbesondere thermisches Verdampfen, Laserstrahlverdampfen, Lichtbogenverdampfen, Molekularstrahlepitaxie, Sputtern, chemische Gasphasenabscheidung (CVD) und/oder Atomlagenabscheidung (ALD).

11. System umfassend
- einen modulierbarer Infrarot-Emitter (1) gemäß einem der vorherigen Ansprüche 1-8
- eine Steuereinrichtung
**dadurch gekennzeichnet, dass**
die Steuereinrichtung konfiguriert ist zur Regulation des Aktuators zur Änderung der Form und/oder Struktur des MEMS-Heizelementes (3) zwischen einem ersten und zweiten Zustand, sodass das Verhältnis der Emissionsfläche (10) zur Gesamtfläche (9) des MEMS-Heizelements (3) in dem ersten Zustand um mindestens einen Faktor 2 geringer ist, als in dem zweiten Zustand.

12. System nach dem vorherigen Anspruch
**dadurch gekennzeichnet, dass**
die Steuereinrichtung konfiguriert ist zur Regulation der Temperatur der erhitzbaren Bereiche (7) des MEMS-Heizelements (3), bevorzugt in einem Bereich zwischen 50 °C und 1000 °C und/oder
die Steuereinrichtung konfiguriert ist den Aktuator (5) für eine oszillierende Zustandsänderung der Form und/oder Struktur des Heizelementes (3) zu regulieren, wobei bevorzugt eine Modulationsfrequenz der Leistungsintensität der emittierten Infrarotstrahlung (29) zwischen 10 Hz und 100 kHz erreicht wird.

13. Verfahren zur modulierten Emission von Infrarotstrahlung
umfassend
- Bereitstellen eines modulierbaren Infrarot-Emitters (1) gemäß einem der vorherigen Ansprüche 1-8 oder eines Systems gemäß den Ansprüchen 11 oder 12;
- Erhitzen der erhitzbaren Bereiche (7) des MEMS-Heizelementes (3) zur Emission einer Infrarotstrahlung;
- Steuerung des Aktuators (5) zur Änderung der Form und/oder Struktur des MEMS-Heizelementes (3) zwischen einem ersten und zweiten Zustand, sodass das Verhältnis der Emissionsfläche (10) zur Gesamtfläche (9) des MEMS-Heizelements (3) in dem ersten Zustand um mindestens einen Faktor 2 geringer ist, als in dem zweiten Zustand.

14. Verwendung eines modulierbaren Infrarot-Emitters (1) gemäß der Ansprüche 1 - 8 oder eines Systems gemäß der Ansprüche 11 oder 12 für die photoakustische Spektroskopie und/oder Infrarotspektroskopie.

15. Photoakustisches Spektroskop zur Analyse von Gas, umfassend
- einen modulierbaren Infrarot-Emitter (1) gemäß einem der vorherigen Ansprüche 1 - 8 oder eines Systems gemäß einem der Ansprüche 11 oder 12,
- ein mit Gas befüllbares Analysevolumen und
- einen Schalldetektor,
wobei das Analysevolumen zwischen dem Infrarot-Emitter und dem Schalldetektor angeordnet ist, sodass die von dem Infrarot-Emitter modulierbar emittierte Infrarotstrahlung zur photoakustischen Spektroskopie des Gases genutzt werden kann.
